(19) Europäisches Patentamt / European Patent Office / Office européen des brevets

(11) **EP 4 752 636 A1**

(12) **EUROPEAN PATENT APPLICATION**

(43) Date of publication:
03.06.2026 Bulletin 2026/23

(21) Application number: 24216497.8

(22) Date of filing: **29.11.2024**

(51) International Patent Classification (IPC):
*G03F 7/20* [(2006.01)]

(52) Cooperative Patent Classification (CPC):
G03F 7/705; G03F 7/70625; G03F 7/70633;
G03F 7/70641; G03F 7/7065

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventor: OLIVEIRA DE MATOS REIS, Jonatha
5500 AH Veldhoven (NL)

(74) Representative: ASML Netherlands B.V.
Corporate Intellectual Property
P.O. Box 324
5500 AH Veldhoven (NL)

(54) **METHOD OF ESTIMATING A PERFORMANCE PARAMETER DISTRIBUTION ON A SUBSTRATE WITH PLURAL EXPOSURE FIELDS AND ASSOCIATED APPARATUS**

(57) Disclosed is a method of estimating values of a performance parameter on a substrate: providing a plurality of first differences between measured values of the performance parameter obtained after having measured the performance parameter at multiple different locations across at least a first portion of the substrate and estimated values of the performance parameter obtained at the same respective locations using a first fitted fingerprint model for estimating a first spatial distribution of the performance parameter over the at least a first portion of the substrate; defining one or more zones within the at least a first portion of the substrate, wherein each zone comprises a first exposure field and at least part of one or more second exposure fields; and estimating the values of the performance parameter over the first exposure field of each of the one or more zones from said plurality of first differences.

Fig. 7

EP 4 752 636 A1

**Description**

FIELD

The present invention relates to methods and apparatus for applying patterns to a substrate in a lithographic process.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40$\mu$m by 40$\mu$m, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In performing lithographic processes, such as application of a pattern on a substrate or measurement of such a pattern, process control methods are used to monitor and control the process. Such process control techniques are typically performed to obtain corrections for control of the lithographic process. It would be desirable to improve such process control methods.

At present, a two-step fingerprint estimation method is used to estimate a fingerprint across a field/sub-field. The first step comprises performing a global fingerprint estimation and the second step comprises performing a field fingerprint estimation. Such a two-step fingerprint estimation method ignores the close interactions between fields. These field-to-field interactions can cause local shapes in the substrate that cannot always be captured by the global fingerprint models and the field fingerprint models. Consequently, the estimation accuracy of this method is suboptimal. Therefore, it is desirable to provide an improved (e.g., more accurate) fingerprint estimation method that addresses the above problem by taking account of field-to-field interactions.

## SUMMARY OF THE INVENTION

In a first aspect of the invention, there is provided a method of estimating values of a performance parameter on a substrate, the substrate being divided into a plurality of exposure fields, the method comprising: providing a plurality of first differences between measured values of the performance parameter obtained after having measured the performance parameter at multiple different locations across at least a first portion of the substrate and estimated values of the performance parameter obtained at the same respective locations using a first fitted fingerprint model for estimating a first spatial distribution of the performance parameter over the at least a first portion of the substrate; defining one or more zones within the at least a first portion of the substrate, wherein each zone comprises a first exposure field and at least part of one or more second exposure fields; and estimating the values of the performance parameter over the first exposure field of each of the one or more zones from said plurality of first differences. In other words, in the step of providing a plurality of first differences, it is provided a plurality of first differences between measured values of the performance parameter and estimated values of the performance parameters. The measured values of the performance parameter may be obtained after having measured the performance parameter at multiple different locations across at least a first portion of the substrate. The estimated values of the performance parameter may be obtained at the same respective locations using a first fitted fingerprint model for estimating a first spatial distribution of the performance parameter over the at least a first portion of the substrate.

In other aspects of the invention, there is provided a computer program comprising program instructions operable to perform the method of the first aspect when run on a processing resource, a non-transient computer program carrier comprising such a computer program, a processing resource comprising a processor and such a non-transient computer program carrier with such a computer program, and a lithographic apparatus or a metrology apparatus or a bonding apparatus comprising such a processing resource. The bonding apparatus is configured to bond a first substrate to a second substrate.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

## BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for semiconductor devices;
Figure 2 shows exemplary sources of processing parameters;
Figure 3 illustrates schematically a current method of determining corrections for control of a lithographic apparatus;
Figure 4 schematically depicts a semiconductor substrate;
Figure 5A schematically depicts a first fingerprint model of performance parameter P;
Figure 5B schematically depicts a second fingerprint model of performance parameter P;
Figure 6 is a flowchart of a method of estimating values of a performance parameter on a substrate, in accordance with an embodiment; and
Figure 7 schematically depicts three example zones defined on a substrate divided into a plurality of exposure fields, in accordance with an embodiment.

## DETAILED DESCRIPTION

Before describing embodiments of the invention in detail, it is instructive to present an example environment in which embodiments of the present invention may be implemented.

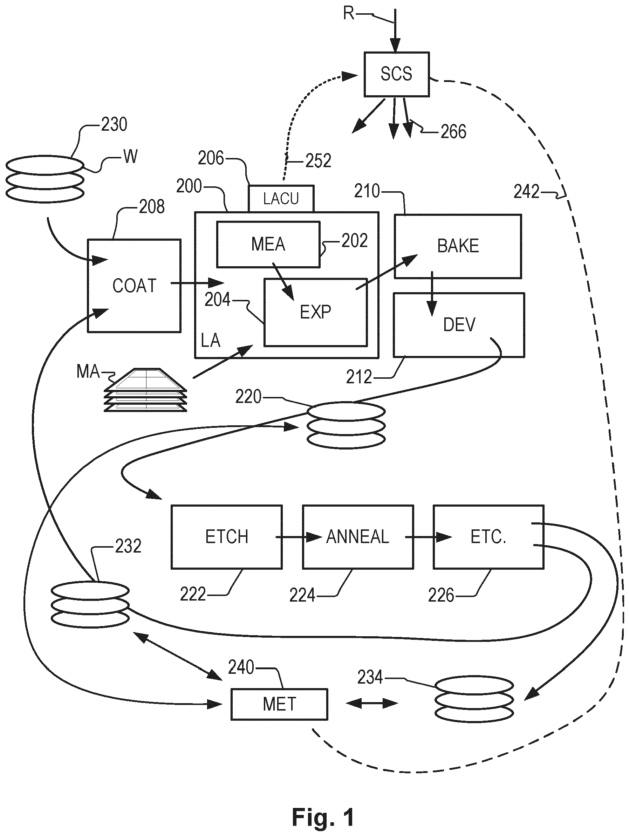

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a pattern transfer unit or projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Various techniques may be used to improve the accuracy of reproduction of patterns onto a substrate. Accurate reproduction of patterns onto a substrate is not the only concern in the production of ICs. Another concern is the yield, which generally measures how many functional devices a device manufacturer or a device manufacturing process can produce per substrate. Various approaches can be employed to enhance the yield. One such approach attempts to make the production of devices (e.g., imaging a portion of a design layout onto a substrate using a lithographic apparatus such as a scanner) more tolerant to perturbations of at least one of the processing parameters during processing a substrate, e.g., during imaging of a portion of a design layout onto a substrate using a lithographic apparatus. The concept of overlapping process window (OPW) is a useful tool for this approach. The production of devices (e.g., ICs) may include other steps such as substrate measurements before, after or during imaging, loading or unloading of the substrate, loading or unloading of a patterning device, positioning of a die underneath the projection optics before exposure, stepping from one die to another, etc. Further, various patterns on a patterning device may have different process windows (i.e., a space of processing parameters under which a pattern will be produced within specification). Examples of pattern specifications that relate to a potential systematic defect include checks for necking, line pull back, line thinning, CD, edge placement, overlapping, resist top loss, resist undercut and/or bridging. The process window of all or some (usually patterns within a particular area) of the patterns on a patterning device may be obtained by merging (e.g., overlapping) process windows of each individual pattern. The process window of these patterns is thus called an overlapping process window. The boundary of the OPW may contain boundaries of process windows of some of the individual patterns. In another words, these individual patterns limit the OPW. These individual patterns can be referred to as "hot spots" or "process window limiting patterns (PWLPs)," which are used interchangeably herein. When controlling a lithography process, it is possible, and typically economical, to focus on the hot spots. When the hot spots are not defective, it is likely that all the patterns are not defective. The imaging becomes more tolerant to perturbations when values of the processing parameters are closer to the OPW if the values of the processing parameters are outside the OPW, or when the values of the processing parameters are farther away from the boundary of the OPW if the values of the processing parameters are inside the OPW.

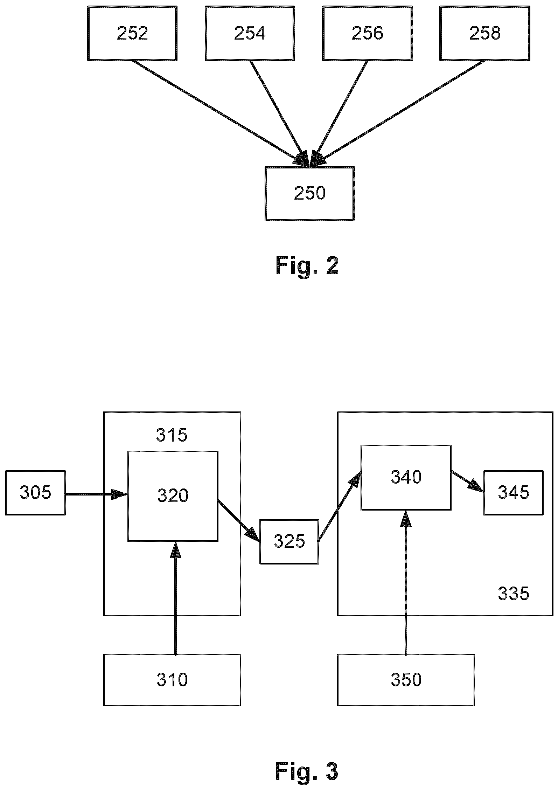

Figure 2 shows exemplary sources of processing parameters 250. One source may be data 252 of the processing apparatus, such as parameters of the source, projection optics, substrate stage, etc. of a lithography apparatus, of a track, etc. Another source may be data 254 from various substrate metrology tools, such as a substrate height map, a focus map, a critical dimension uniformity (CDU) map, etc. Data 254 may be obtained before the applicable substrate was subject to a step (e.g., development) that prevents reworking of the substrate. Another source may be data 256 from one or more patterning device metrology tools, patterning device CDU map, patterning device (e.g., mask) film stack parameter variation, etc. Yet another source may be data 258 from an operator of the processing apparatus.

Control of the lithographic process are typically based on measurements fed back or fed forward and then modelled using, for example interfield (across-substrate fingerprint) or intrafield (across-field fingerprint) models. Within a die, there may be separate functional areas such as memory areas, logic areas, contact areas etc. Each different functional area, or different functional area type may have a different process window, each with a different processes window center. For example, different functional area types may have different heights, and therefore different best focus settings. Also, different functional area types may have different structure complexities and therefore different focus tolerances (focus process windows) around each best focus. However, each of these different functional areas will typically be formed using the same focus (or dose or position etc.) setting due to control grid resolution limitations.

The lithographic control is typically performed using offline calculation of one or more set-point corrections for one or more particular control degrees of freedom, based on (for example) measurements of previously formed structures. The set-point corrections may comprise a correction for a particular process parameter, and may comprise the correction of a setting of a particular degree of freedom to compensate for any drift or error such that the measured process parameter remains within specification (e.g., within an allowed variation from a best set-point or best value; for example, an OPW or process window). For example, an important process parameter is focus, and a focus error may manifest itself in a defective structure being formed on a substrate. In a typical focus control loop, a focus feedback methodology may be used. Such a methodology may comprise a metrology step which may measure the focus setting used on a formed structure; e.g., by using diffraction based focus (DBF) techniques in which a target with focus dependent asymmetry is formed such that the focus setting can be subsequently determined by measurement of the asymmetry on the target. The measured focus setting may then be used to determine, offline, a correction for the lithographic process; for example a positional correction for one or both of the reticle stage or substrate stage which corrects the focus offset (defocus). Such an offline positional correction may then be conveyed to the scanner as a set-point best focus correction, for direct actuation by the scanner. The measurements may be obtained over a number of lots, with an average (over the lots) best focus correction applied to each substrate of one or more subsequent lots. Similar control loops are used in the other two dimensions (substrate plane) to control and minimize overlay error.

Figure 3 illustrates such a methodology. It shows product information 305, such as product layout, illumination mode, product micro-topography etc., and metrology data 310 (e.g., defocus data or overlay data measured from previously produced substrates) being fed to an offline processing device 315 which performs an optimization algorithm 320. The output of the optimization algorithm 320 is one or more set-point corrections/offsets 325, e.g., for actuators which control reticle stage and/or substrate stage positioning (in any direction, i.e., in the x, y and/or z directions, where x and y are the substrate plane direction and z is perpendicular to x and y) within scanner 335; the set-point corrections 325 being calculated to compensate for any offsets/errors (e.g., defocus, dose or overlay offsets/errors) comprised within the metrology data 310. A control algorithm 340 (e.g., leveling algorithm) calculates control set-points 345 using substrate specific metrology data 350. For example, a leveling exposure trajectory (e.g., determining a relative movement or acceleration profile for positioning of the substrate stage relative to the reticle stage during the lithographic process) may be calculated using leveling data (e.g., a wafer height map) and outputs positional set-points 345 for the scanner actuators. The scanner 335 directly applies, equally for each substrate, the set-point corrections 325 to the calculated set-points 345. In other control arrangements, the optimization may be performed within the scanner to provide optimized corrections on a per-wafer basis (wafer-to-wafer control).

The optimization algorithm (e.g., as performed within an offline processing device and/or scanner) may be based on a number of different merit functions, one for each control regime. As such, in the example described above, a levelling (or focus) merit function is used for the focus control (scanner z direction control), which is different to an overlay (scanner x/y direction control) merit function, a lens aberration correction merit function etc.. In other embodiments, control may be co-optimized for one or more of these control regimes.

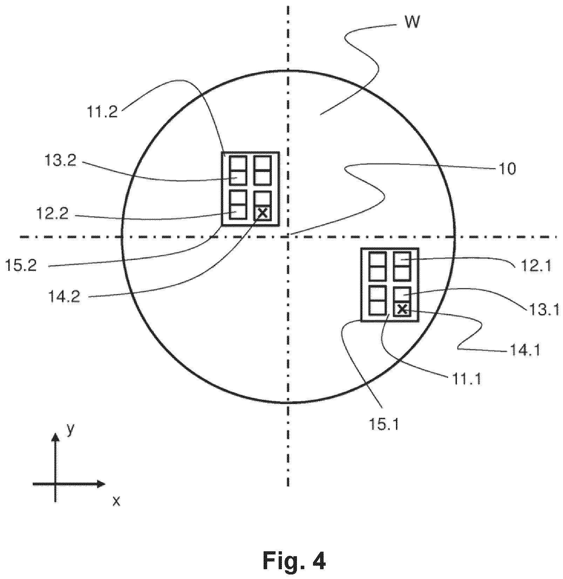

Figure 4 schematically shows a semiconductor substrate W. The semiconductor substrate W has a generally circular shape with a center 10.

The semiconductor substrate W (or "substrate W" for short) contains a plurality of fields 11.1, 11.2, of which 2 are schematically indicated in Figure 4. A field is for example the area of the substrate W which is irradiated between subsequent moves of the stage relative to the projection system. In this example, each field 11.1, 11.2 is formed by multiple dies 12.1, 12.2, which are also schematically indicated in Figure 4. So, in this example, a die is smaller than a field. After processing the substrate, the dies will form the individual microchips. In another example, a die may comprise multiple fields. So in that example, a die is larger than a field. Each die optionally contains multiple cells 13.1, 13.2, which are also schematically indicated in Figure 4. So, a cell is an area within a die. A cell is smaller than a die. Figure 4 shows two fields 11.1, 11.2. In Figure 4, each field contains four dies, e.g. 12.1, 12.2. In Figure 4, each die contains two cells, e.g. 13.1, 13.2. The number of fields, dies, and cells may be different.

The value of a performance parameter may vary with the position of a point 14.1, 14.2 on the substrate W, e.g. the radial distance from the point to the center 10 of the substrate W. In some cases, it is known this variation can be described by means of a mathematical model, e.g. a polynomial, but the model parameters may vary between individual substrates W.

For example, it can be known that the value of a performance parameter at a point 14.1. 14.2 is dependent from the radial distance to the center 10 of the substrate, and that the value follows a parabolic curve. The mathematical model to describe the parameter value is then a second order polynomial, which can be written as: $p1 = aR^2 + bR + c$, in which $p1$ represents the value of the performance parameter P in relation to the substrate W, R is the radial distance of a point to center 10 of the substrate W and a, b, and c are model parameters. The mathematical model may or may not include periodicity. An example of a mathematical model which includes periodicity is a sine wave.

The model parameters for each individual substrate can be determined by carrying out measurements at sample points. The sample points are locations on the substrate W at which measurements are performed with the aim of providing measurement data from which the model parameters a, b, and c can be determined. A plurality of sampling points together forms a sampling scheme. Once model parameters a, b and c are determined, the distribution of the performance parameter can be predicted for locations where the measurements were not performed and thus the performance parameter measurement data can be densified. The densified performance parameter measurement data can be used to control the lithographic apparatus with an increased accuracy, because the knowledge of the values of the densified performance parameter measurement data and/or the model parameters of the model for the performance parameter allows to compensate for errors or other deviations.

If the sampling scheme contains a large number of sampling points, the performance parameter distribution can be determined accurately. However, it takes a long time to perform the measurements that are necessary to determine the model parameters, which reduces the throughput of the lithographic process. Therefore, it is advantageous if the number of sampling points in a sampling scheme can be reduced.

The value of a performance parameter may not only vary with the position of a point 14.1, 14.2 on the substrate W, but also with the position of that point 14.1, 14.2 within a field 11.1, 11.2, die 12. 1, 12.2 or cell 13.1, 13.2, for example with the distance in x-direction or in y-direction from a corner 15.1, 15.1 of the field 11.1, 11.2 in which the point 14.1, 14.2 is located. The mathematical model describing the variation of the value of the performance parameter may be the same as or different from the mathematical model that describes the variation of that performance parameter over the surface of the substrate face as a whole. For example, the variation of the performance parameter within a field 11.1, 11.2 as dependent on the distance in x-direction from corner point 15.1, 15.2 of that field 11.1, 11.2 can be written as: $p2 = fY + g$, wherein $p2$ represents the value of performance parameter P in relation to the field 11.1, 11.2, Y is the distance in y-direction from the point 14.1, 14.2 to the corner point 15.1, 15.2 of the respective field 11.1, 11.2, and f and g are model parameters.

When considering the points 14.1 and 14.2 as depicted in Figure 4, the value of performance parameter P, which is dependent from the position of the point 14.1, 14.2 on the substrate W in general will be different between point 14.1 and point 14.2, because these points are located at a different radial distance from the center 10 of the substrate W. However, the value of the performance parameter P will be the same or at least similar for points 14.1 and 14.2 as they are located at the same distance in y-direction from the corner points 15.1, 15.2 of their respective field 11.1, 11.2. Taking these considerations into account in the control of process in the lithographic apparatus (e.g. in the control of the movement of the substrate relative to a projection system of the lithographic apparatus) can help to increase the accuracy of the lithographic process.

The spatial distribution of a performance parameter over the semiconductor substrate or a part thereof (i.e. the variation of the value of a performance parameter over the semiconductor substrate or a part thereof) is called a "fingerprint". The fingerprint may also vary over time due to e.g. process changes over time. The fingerprint model is a mathematical model that models the fingerprint over the substrate W or a part of the substrate W. The fingerprint model contains a number of model parameters (e.g. the parameters a, b, c, f and g in the examples given above). The same fingerprint model may be used for a group of substrates W, e.g. the substrates W of one or more lots, or even all substrates W which are processed on the same lithographic apparatus. However, the model parameters may vary from individual substrate W to individual substrate W.

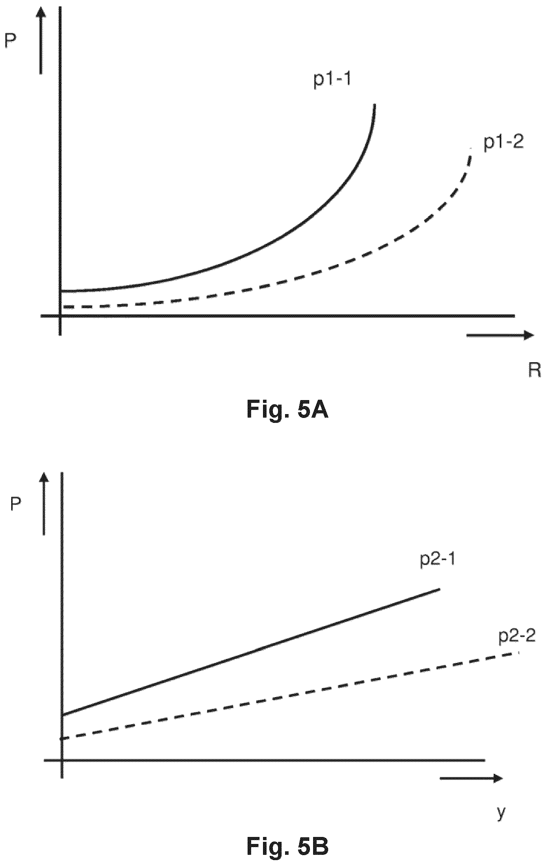

Figures 5A and 5B illustrate this. Figure 5A shows a graph representing the value p1 of performance parameter P as dependent on the radial distance R from the center 10 of the substrate. Line p1-1 represents the variation of the value of P in a first substrate, and line p1-2 represents the variation of the value of P in a second substrate. While the shape of the lines p1-1, p1-2 can be described by the same kind of polynomial (the "fingerprint model"), the parameters of that polynomial vary between lines p1-1 and p1-2. For example, if the polynomial representing both lines p1-1 and p1-2 can be written as aR2 + bR + c, the values for the model parameters a, b and c are different for line p1-1 and line p1-2.

Figure 5B shows a graph representing the value p2 of performance parameter P as dependent on the distance in y-direction Y from the corner 15.1, 15.2 of a filed 11.1, 11.2. Line p2-1 represents the variation of the value of P in a first substrate, and line p2-2 represents the variation of the value of P in a second substrate. While the shape of the lines p2-1, p2-2 can be described by the same kind of polynomial (the "fingerprint model"), the parameters of that polynomial vary between lines p2-1 and p2-2. For example, if the polynomial representing both lines p1-1 and p1-2 can be written as fY + g, the values for the model parameters f and g are different for line p2-1 and line p2-2.

A fingerprint model is for example obtained by first obtaining the fingerprint and then transforming the obtained fingerprint into a mathematical model that is representative of the obtained fingerprint. The fingerprint can for example be obtained by measuring the performance parameter in a semiconductor substrate or a group of semiconductor substrates at plurality of measuring locations. In general, to obtain the fingerprints, measurements must be performed at a high number of measuring locations. Alternatively or in addition, the fingerprint may be obtained by simulating the performance parameter in a computer model, and obtaining the spatial distribution of the value of that performance parameter over the semiconductor substrate or a part thereof.

From the obtained fingerprint, the fingerprint model can for example be obtained by the determination of a pattern in the spatial distribution of the measured performance parameter, e.g. by curve fitting. For example, WO2013/092106 described is paragraphs [0108]-[0129] how a correction model can be applied to measured data in order to calculate model parameters. So, the fingerprint model is a mathematical model which is determined based on the domain knowledge. Then, measurements are performed at sampling locations. The fingerprint model comprising the model parameters are fitted to the measurements. Then the model parameters are determined by the fitting. The fitted fingerprint model (i.e. the fingerprint model with the model parameters fitted to the measurement data) can predict the performance parameter value at any locations on the substrate W, typically at locations where no measurements were performed. In this way, the fitted fingerprint model enables to "model" or "densify" the measurements across the entire substrate W while keeping the number of measurements reasonably low. This allows to obtain a good balance between throughput and accuracy.

The control architecture of a lithographic apparatus is configured to control the performance (overlay, CD, focus for example) at both intra-field level and inter-field level. Recent developments (WO 2016146217 A1, WO 2018121921 A1) enabled also control at spatial scales smaller than a field. The control architecture of state of the art scanners also allows control at sub-field level. The definition of the sub-field regarding its size and/or shape may be chosen in line with the spatial variation of the performance parameter(s), typically depending on the layout of the fields, dies and cells across the substrate. The sub-field based control architecture provides enhanced flexibility of control to the lithographic apparatus. For example, a particular layout (distribution) of die/cells across a field may cause a corresponding stress distribution within the field which causes in-plane wafer deformation of the field inducing a corresponding fingerprint of a performance parameter (error) fingerprint. In case the stress distribution is periodic the fingerprint may show a repetitive (periodic) pattern across the field. This kind of fingerprint may be efficiently corrected by the lithographic apparatus in case a sub-field based control interface is available, wherein the sub-field is defined to cover a single or discrete number of periods comprised within the repetitive patterns so that fingerprint corrections per sub-field are typically substantially identical (e.g. each correction targeted to correct the same periodic performance parameter fingerprint).

When fingerprints at different spatial scales, e.g. a whole substrate and a field, a field and a sub-field, etc., are identified, it is beneficial to correct these fingerprints by controlling the lithographic apparatus based on the identified fingerprints.

At present, a two-step fingerprint estimation method is used to estimate a fingerprint across a field/sub-field. The first step of such a two-step fingerprint estimation method comprises performing a global fingerprint estimation, which may be achieved through the following three sub-steps: 1) selecting a suitable global fingerprint model; 2) fitting the selected global fingerprint model to a set of global measurement data which comprises a plurality of values of a performance parameter (e.g., overlay error, critical dimension, alignment mark position, side wall angle, edge roughness, edge placement error, and focus error) measured respectively at a plurality of different locations across a whole substrate; and 3) determining the model parameters of the global fingerprint model and a set of global fitting residual data by the model fitting. As mentioned above, the fitted global fingerprint model (i.e. the global fingerprint model with the model parameters determined by the model fitting) can predict the performance parameter value at any locations on the substrate W, typically at locations where no measurements were performed. The set of global fitting residual data comprises differences between the measured values of the performance parameter obtained at respective different locations and the estimated values of the performance parameter determined by the fitted global fingerprint model for the same measurement locations. The global fitting residual data is then used for subsequent field fingerprint estimation (see below).

The second step of the two-step fingerprint estimation method comprises performing a field fingerprint estimation, which may be achieved through the following four sub-steps: 1) selecting a portion (or subset) of the global fitting residual data associated with measurement locations encompassed within a specific field over which a fingerprint of a performance parameter is to be estimated; 2) selecting a suitable field fingerprint model; 3) fitting the selected field fingerprint model to the selected portion of the global fitting residual data; and 4) determining the model parameters of the field fingerprint model and a set of field fitting residual data by the model fitting. The fitted field fingerprint model (i.e. the field fingerprint model with the model parameters determined by the model fitting) can predict the performance parameter value at any locations within the field. The set of field fitting residual data comprises differences between the measured values of the performance parameter obtained at respective different locations within the field and the estimated values of the performance parameter determined by the fitted field fingerprint model for the same measurement locations.

An example implementation of such a two-step fingerprint estimation approach will now be described in detail. First, a set of global measurement data is obtained after measuring a performance parameter (e.g., overlay data) at multiple (e.g., 10) different locations across a substrate. The example set of global measurement data comprises the following values:

$$x_i = [-1.00, \ -0.778, \ -0.5556, \ -0.3333, \ 0.1111, \ 0.1111, \ 0.3333, \ 0.5556, \ 0.778, \ 1.00],$$
$$(i = [1, 2, \dots 10]) \qquad [1]$$

$$y_i = [1.0084, \ 0.3888, \ 0.1866, \ 0.0276, \ 0.0827, \ 0.0540, \ 0.1120, \ 0.1031, \ 0.4102, \ 1.0107],$$
$$(i = [1, 2, \dots 10]) \qquad [2]$$

where $x_i$ denotes the measurement positions on the substrate, and $y_i$ denotes the values of the performance parameter measured at the respective measurement positions $x_i$.

In this example implementation, a second order (or quadratic) polynomial, i.e. y(x) = a + bx + cx$^2$, is selected as the global fingerprint model. In the context of the present application, the coefficients $a$, $b$, $c$ of the quadric polynomial are regarded as the model parameters of the global fingerprint model. The default values of the model parameters may be set to 1 (i.e. $a$ = 1, $b$ = 1, c = 1). As such, a design matric may be defined as:

$$C = x^0 + x^1 + x^2. \quad [3]$$

Applying the measurement positions $x_i$ to the design matrix C (as expressed by equation [3]) leads to the following design matrix, in which each column corresponds to one of the terms of the polynomial and each row corresponds to one of the measurement positions $x_i$:

$$C_i = \begin{bmatrix} x_i^0 & x_i^1 & x_i^2 \end{bmatrix} =$$
$$[1.0000 \quad -1.0000 \quad 1.0000$$
$$1.0000 \quad -0.7778 \quad 0.6049$$
$$1.0000 \quad -0.5556 \quad 0.3086$$
$$1.0000 \quad -0.3333 \quad 0.1111$$
$$1.0000 \quad -0.1111 \quad 0.0123$$
$$1.0000 \quad 0.1111 \quad 0.0123$$
$$1.0000 \quad 0.3333 \quad 0.1111$$
$$1.0000 \quad 0.5556 \quad 0.3086$$
$$1.0000 \quad 0.7778 \quad 0.6049$$
$$1.0000 \quad 1.0000 \quad 1.0000], (i = [1, 2, \dots 10]). \quad [4]$$

By fitting the design matrix $C_i$ (as expressed by equation [4]) to the measured values $y_i$ of the performance parameter, the model parameters can be determined by:

$$p = \left(C_i{}^t * C_i\right)^{-1} C_i * y_i = [-0.0509, \quad -0.0006, \quad 0.9555], \qquad [5]$$

which means $a$ = -0.0509, $b$ = -0.0006, $c$ = 0.9555. Accordingly, the fitted global fingerprint model $y_{fit}(x)$ is expressed as:

$$y_{fit}(x) = -0.0509 - 0.0006x + 0.9555x^2. \qquad [6]$$

The global model fitting results in a set of global fitting residuals which are the differences between the measured values $y_i$ of the performance parameter obtained at respective measurement positions $x_i$ and the estimated values $y_{fit}(x_i)$ of the performance parameter determined by the fitted global fingerprint model $y_{fit}(x)$ (as expressed by equation [6]) for the same measurement positions:

$$res = [-0.103, \quad 0.139, \quad 0.058, \quad 0.028, \quad -0.1218, \quad -0.093, \quad -0.0569, \quad 0.1406, \quad 0.1164, \quad -$$
$$0.107]. \qquad [7]$$

The above global fitting residuals (or global fitting residual data) will then be used for the second step, i.e. field fingerprint estimation. In the second step, the measurement positions $x_i$ are split into two regions. The first region x1 is defined by the first five positions of $x_i$ and is expressed as:

$$x1_i = [-1.00, \quad -0.778, \quad -0.5556, \quad -0.3333, \quad -0.1111]; (i = [1, 2, \dots 5]) \qquad [8]$$

the second region x2 is defined by the remaining five positions of $x_i$ and is expressed as:

$$x2_i = [0.1111, \quad 0.3333, \quad 0.5556, \quad 0.778, \quad 1.00]. (i = [1, 2, \dots 5]) \qquad [9]$$

The field fingerprint model may be same as or different to the global fingerprint model. For the sake of simplicity, a quadratic polynomial ($y(x)$ = a + bx + cx$^2$) is also used as the field fingerprint model and the default values of the model parameters ($a$, $b$, $c$) are also set to 1. Applying the measurement positions of the first region x1 to the design matrix C (as expressed by equation [3]) leads to a first design matrix $C1_i$ which is expressed as:

$$C1_i = \left[x1_i^0 \quad x1_i^1 \quad x1_i^2\right] =$$
$$[\,1.0000 \quad -1.0000 \quad 1.0000$$
$$1.0000 \quad -0.7778 \quad 0.6049$$
$$1.0000 \quad -0.5556 \quad 0.3086]$$
$$1.0000 \quad -0.3333 \quad 0.1111$$
$$1.0000 \quad -0.1111 \quad 0.0123]. (i = [1, 2, \dots 10]) \; [10]$$

Similarly, applying the measurement positions of the second region x2 to the design matrix C (as expressed by equation [3]) leads to a second design matrix $C2_i$ which is expressed as:

$$C2_i = \begin{bmatrix} x2_i^0 & x2_i^1 & x2_i^2 \end{bmatrix} =$$

$$\begin{bmatrix} 1.0000 & 0.1111 & 0.0123 \\ 1.0000 & 0.3333 & 0.1111 \\ 1.0000 & 0.5556 & 0.3086 \\ 1.0000 & 0.7778 & 0.6049 \\ 1.0000 & 1.0000 & 1.0000 \end{bmatrix}, (i = [1, 2, \dots 10]) \quad [11]$$

The global fitting residuals *res* (as expressed by [7]) are also split into two regions. The first region $res1_i$ is defined by the first five fitting residuals and is expressed as:

$$res1_i = [-0.103, \ 0.139, \ 0.058, \ 0.028, \ -0.1218]; \ (i = [1, 2, \dots 5]) \ [12]$$

and the second region $res2_i$ is defined by the remaining five fitting residuals and is expressed as:

$$res2_i = [-0.093, \ -0.0569, \ 0.1406, \ 0.1164, \ -0.107]. \ (i = [1, 2, \dots 5]) \quad [13]$$

By fitting the first design matrix $C1_i$ (as expressed by equation [10]) to the global fitting residuals of the first region $res1_i$ the model parameters can be determined by:

$$p1 = \left(C1_i^{\ t} * C1_i\right)^{-1} C1_i * res1_i = [-0.2593 \ \ -1.2431 \ \ -1.0588], \ [14]$$

which means *a* = -0.2593, *b* = -1.2431, *c* = -1.0588. Accordingly, the fitted global fingerprint model for the first region is expressed as:

$$y1_{fit}(x) = -0.2593 - 1.2431x - 1.0588x^2. \quad [15]$$

By fitting the second design matrix $C2_i$ (as expressed by equation [10]) to the global fitting residuals of the second region $res2_i$, the model parameters can be determined by:

$$p2 = \left(C2_i^{\ t} * C2_i\right)^{-1} C2_i * res2_i = [-0.2613 \ \ 1.2557 \ \ -1.0709], \quad [16]$$

which means *a* = -0.2613, *b* = 1.2557, *c* = -1.0709. Accordingly, the fitted global fingerprint model for the second region is expressed as:

$$y2_{fit}(x) = -0.2613 + 1.2557x - 1.0709x^2. \quad [17]$$

Similar to the global model fitting as described above, for both the first region and the second region, the field model fitting will also result in a set of field fitting residuals which are differences between the global fitting residuals of the first region $res1_i$ or the second region $res2_i$ and the estimated global fitting residuals determined by the fitted field fingerprint model (as expressed by equation [15] or equation [17]) for the same locations. The field fitting residuals are not provided herein for the sake of simplicity.

The above-described two-step fingerprint estimation method ignores the close interactions between fields. These field-to-field interactions can cause local shapes in the substrate that cannot always be captured by the global fingerprint models and the field fingerprint models. Consequently, the estimation accuracy of this method is suboptimal. Therefore, it is desirable to provide an improved (e.g., more accurate) fingerprint estimation method that addresses the above problem by taking account of field-to-field interactions.

Accordingly, one aspect of the present application provides a method of estimating values of a performance parameter on a substrate. The substrate may be divided into a plurality of exposure fields. The proposed method improves the estimation accuracy of the existing two-step method by including an intermediate estimation that is performed after the global fingerprint estimation and before the field fingerprint estimation. Such an intermediate estimation is performed not only based on data associated with a particular field, over which a fingerprint of a performance parameter is to be estimated, but also based on additional data associated with one or more other fields that are adjacent to that the field of interest. As such, the influence of the adjacent fields on the field of interest is included in the (estimated) data resulting from the intermediate estimation on which the subsequent field fingerprint estimation will be based. In other words, the proposed method estimates values of a performance parameter over a field of interest after having taken field-to-field interactions into account and therefore enables a more accurate fingerprint estimation. The proposed method is particularly useful for improving the accuracy in estimating a fingerprint of a performance parameter for edge fields where there is no sufficient data, such as in the case of sparse alignment data.

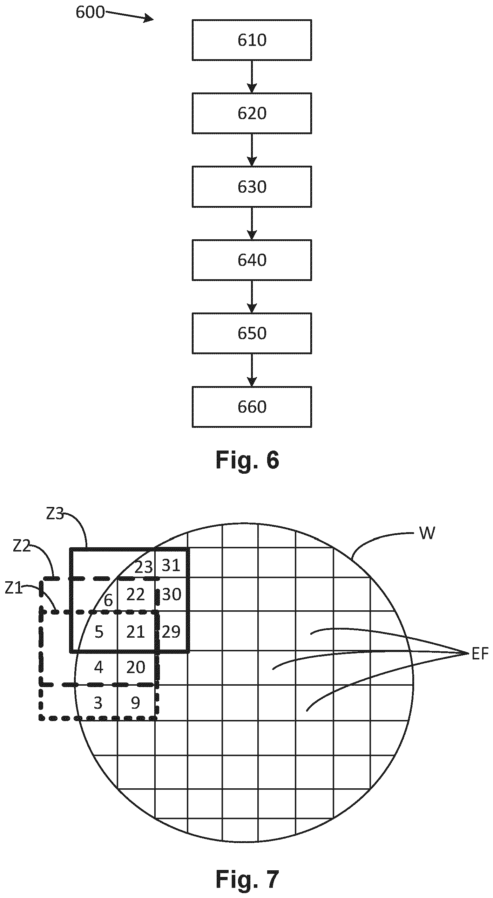

With reference to Figure 6, in an embodiment, the proposed method 600 may comprise for example the following six steps, i.e. steps 610-660.

Step 610 may comprise providing a plurality of first differences between measured values of the performance parameter and estimated values of the performance parameter. Each of the first differences may be a value difference between a respective one of the measured values of the performance parameter and a corresponding one of the estimated values of the performance parameter. The measured values of the performance parameter may be obtained after having measured the performance parameter at multiple different locations across at least a first portion of the substrate. The estimated values of the performance parameter may be obtained at the same respective locations using a first fitted fingerprint model for estimating a first spatial distribution of the performance parameter over the at least a first portion of the substrate. The performance parameter may be one of: overlay error, critical dimension, alignment mark position, side wall angle, edge roughness, edge placement error, and focus error.

In an embodiment, the step of determining the first fitted fingerprint model may comprise measuring the performance parameter at a plurality of different locations across the at least a first portion of the substrate to obtain a set of measurement data comprising measured values of the performance parameter. The measurements may be performed in a metrology apparatus (e.g. metrology apparatus 240 shown in Figure 1). The first portion may be at least a part of an irradiated layer inside or at the top surface of the substrate. It may be that at least one measurement may be performed within each of the exposure fields encompassed within the first portion. In an example implementation, the performance parameter may be measured at a plurality of different locations across the entire area of an irradiated layer inside or at the top surface of the substrate (e.g., the entire area of the substrate) and each exposure field may encompass at least one measurement point. The resultant measurement data may be regarded as global measurement data.

The step of determining the first fitted fingerprint model may further comprise providing a first fingerprint model in relation to the first spatial distribution of the performance parameter over the at least a first portion of the substrate, the first fingerprint model comprising one or more first model parameters. The first fingerprint model may be regarded as a global fingerprint model, which may be in the form of for example a polynomial (e.g., a quadratic polynomial $y(x) = a + bx + cx^2$).

The step of determining the first fitted fingerprint model may further comprise fitting the first fingerprint model to at least some of the measured values of the performance parameter to determine the one or more first model parameters (e.g., the coefficients $a, b, c$ of the quadric polynomial $y(x) = a + bx + cx^2$), thereby obtaining the first fitted fingerprint model (e.g., the fitted global fingerprint model $y_{fit}(x)$ as expressed by equation [6]). The fitting of the first fingerprint model to the measurement data may result in a first set of fitting residuals.

The step of determining the first fitted fingerprint model may further comprise determining the plurality of first differences by comparing measured values of the performance parameter obtained after having measured the performance parameter at multiple different locations across the at least a first portion of the substrate to estimated values of the performance parameter obtained at the same respective locations using the first fitted fingerprint model.

In the case where the first fingerprint model is fitted to the entire set of measurement data, the plurality of first differences may correspond to the first set of fitting residuals resulting directly from the model fitting. As such, there may require no additional data processing. Whereas, in the case where the first fingerprint model is fitted to only a portion of the set of measurement data, the first set of fitting residuals resulting directly from the model fitting may not provide the entire of the plurality of first differences. As such, additional data processing may be required. For example, the first fitted fingerprint model may be used to estimate values for all the measured locations. The estimated values may then be compared to the corresponding measured values at the same respective locations on the substrate so as to obtain the plurality of first differences. Alternatively, the first fitted fingerprint model may be used to estimate values only for those measured locations that were not used for fitting the first fingerprint model. Comparing these estimated values to the corresponding measured values at the same respective locations may result in a set of first differences which may combine with the first set of fitting residuals to form the plurality of first differences.

Step 620 may comprise defining one or more zones within the at least a first portion of the substrate, wherein each zone comprises a first exposure field and at least part of one or more second exposure fields.

The first exposure field may be the field over which a fingerprint is to be estimated. The at least part of one or more second exposure fields may contain additional data which may reflect the interactions between the first exposure field and the one or more exposure fields (i.e. the influence of the one or more second exposure on the first exposure field).

The one or more second exposure fields may be arranged to substantially surround the first exposure field. Although a single second exposure field or a part thereof may provide useful data (e.g., data reflecting field-to-field interactions) that helps improve the accuracy of fingerprint estimation for the first exposure field or a part thereof, it is preferable to include more second exposure fields in a zone as they may provide more additional data and thus may further improve the estimation accuracy. The one or more second exposure fields may comprise for example at least two second exposure fields, at least three exposure fields, at least four exposure fields, at least five exposure fields, or at least six exposure fields.

In an embodiment, the one or more second exposure fields may be immediately adjacent to the first exposure field. Figure 7 schematically depicts three example zones Z1-Z3 on the substrate W each of which comprises multiple exposure fields EFs. The first zone Z1 is centered at exposure field 4 and is defined as the combination of exposure fields 3, 4, 5, 9, 20 and 21. Thus, for the first zone Z1, exposure field 4 may be regarded as the first exposure field and other exposure fields 3, 5, 9, 20 and 21 that surround exposure field 4 may be regarded as the second exposure fields. The second zone Z2 is centered at exposure field 5 and is defined as the combination of fields 4, 5, 6, 20, 21 and 22. Similarly, for the second zone Z2, exposure field 5 may be regarded as the first exposure field and other exposure fields 4, 6, 20, 21 and 22 that surround exposure field 5 may be regarded as the second exposure fields. The third zone is centered at exposure field 22 and is defined as the combination of fields 5, 6, 21, 22, 23, 29, 30 and 31. Similarly, for the third zone Z3, exposure field 22 may be regarded as the first exposure field and other exposure fields 5, 6, 21, 23, 29, 30 and 31 that surround exposure field 22 may be regarded as the second exposure fields.

Note that the first exposure field of a zone may not have to be located in the center of the zone. In other embodiments, the first exposure field may an off-center field. For example, for the second zone Z2, exposure field 20 at the right corner of the zone may be the first exposure field and other exposure fields, i.e. fields 4, 5, 6, 21 and 22 may instead be the second exposure fields.

Note that the zones Z1-Z3 shown in Figure 7 are provided only as an example and by no means impose any limitation on how the zones can be defined. The total number of the zones, and/or the locations of the zones, and/or the sizes of the zones, and/or the shapes of the zones may be flexibly defined, e.g., to meet certain application needs.

In an alternative embodiment, the first exposure field and each of the one or more second exposure fields may be separated by one or more other exposure fields. In such a case, each zone may be formed with multiple discrete areas of the substrate rather than covering a continuous area of the substrate as the zones Z1-Z3 in Figure 7.

Step 630 may comprise determining, for each of the one or more, a second fitted fingerprint model for estimating a second spatial distribution of the performance parameter over the zone based on the plurality of first differences.

In an embodiment, the step of determining the second fitted fingerprint model may comprise providing a second fingerprint model in relation to the second spatial distribution of the performance parameter over each of the one or more zones, the second fingerprint model comprising one or more second model parameters. In an embodiment, the second fingerprint model may be same as the first fingerprint model, which may comprise for example a polynomial (e.g., a quadratic polynomial $y(x) = a + bx + cx^2$). In an alternative embodiment, the second fingerprint model may be different to the first fingerprint model (e.g., a higher order polynomial).

The step of determining the second fitted fingerprint model may further comprise selecting a portion of the plurality of first differences associated with measurement locations encompassed within the corresponding zone (e.g., the first differences encompassed within the first zone Z1 shown in Figure 7).

The step of determining the second fitted fingerprint model may further comprise fitting the second fingerprint model to the selected portion of the plurality of first differences to determine the one or more second model parameters, thereby obtaining the second fitted fingerprint model. This model fitting may be conducted in a similar manner as the fitting of the design matrix $C1_i$ (as expressed by equation [10]) or $C2_i$ (as expressed by equation [11]) to the selected global fitting residuals $res1_i$ (as expressed by equation [12]) or $res2_i$ (as expressed by equation [13]), as described above.

Step 640 may comprise determining, for each of the one or more zones (e.g., zones Z1-Z3 shown in Figure 7), a plurality of second differences by comparing measured values of the performance parameter obtained at multiple different locations within the zone to estimated values of the performance parameter obtained at the same respective locations using the second fitted fingerprint model. The fitting of the second fingerprint model to the measurement data may result in a second set of fitting residuals.

In the case where the second fingerprint model is fitted to all the first differences encompassed within the corresponding zone, the plurality of second differences may correspond to the second set of fitting residuals resulting directly from the model fitting. As such, no additional data processing may be required. Whereas, in the case where the second fingerprint model is fitted to only a portion of the first differences encompassed within the corresponding zone, the second set of fitting residuals resulting directly from the model fitting may not provide the entire of the plurality of second differences. As such, additional data processing may be required. For example, the second fitted fingerprint model may be used to estimate values for all the measured locations within the corresponding zone. The estimated values may then be compared to the corresponding measured values at the same respective locations so as to obtain the plurality of second differences. Alternatively, the second fitted fingerprint model may be used to estimate values only for those measured locations that were not used for fitting the second fingerprint model. Comparing these estimated values to the corresponding measured values at the same respective locations may result in a set of second differences which may combine with the second set of fitting residuals to form the plurality of second differences.

Step 650 may comprise determining, for each of the one or more zones, a third fitted fingerprint model for estimating a third spatial distribution of the performance parameter over the first exposure field of the corresponding zone based on the plurality of second differences.

In an embodiment, the step of determining the third fitted fingerprint model may comprise providing a third fingerprint model in relation to the third spatial distribution of the performance parameter over the first exposure field of the corresponding zone, the third fingerprint model comprising one or more third model parameters. The third fingerprint model may be different to the first fingerprint model and/or the second fingerprint model. The third fingerprint model may be regarded as a field fingerprint model, which may be in the form of for example a polynomial.

The step of determining the third fitted fingerprint model may further comprise selecting a portion (or subset) of the plurality of second differences encompassed within the first exposure field (e.g., exposure field 5 shown in Figure 7) of the corresponding zone (e.g., zone Z2 shown in Figure 7).

The step of determining the third fitted fingerprint model may further comprise fitting the third fingerprint model to the selected portion of the plurality of second differences to determine the one or more third model parameters, thereby obtaining the third fitted fingerprint model. This model fitting may be conducted in a similar manner as the fitting of the design matrix $C1_i$ (as expressed by equation [10]) or $C2_i$ (as expressed by equation [11]) to the selected global fitting residuals $res1_i$ (as expressed by equation [12]) or $res2_i$ (as expressed by equation [13]), as described above.

In the case where the first exposure field of a particular zone also falls within one or more other zones (e.g., as one of their second exposure fields), the portion of the plurality of second differences that are associated with measurement locations encompassed within the first exposure field and that will be used to determine the third fitted fingerprint model may be determined in a different manner to the foregoing embodiment. For example, the portion of the plurality of second differences may be determined by combining, in a weighted manner, selected portions of the second differences associated with the respective overlapping zones.

Accordingly, in an embodiment, the step of determining the third fitted fingerprint model may comprise determining that the first exposure field is comprised within at least a first zone and a second zone. Such zones may be regarded as overlapping zones. By way of example and with reference to Figure 7, exposure field 5 is contained within all three zones Z1, Z2 and Z3. Exposure field 5 may be regarded as the first exposure field of the second zone Z2 and as the second exposure field of the first zone Z1 and the third zone Z3.

The step of determining the third fitted fingerprint model may further comprise providing, for each of the overlapping zones (e.g., zones Z1-Z3), a third fingerprint model (e.g., a polynomial) in relation to the third spatial distribution of the performance parameter over the first exposure field of the corresponding zone, the third fingerprint model comprising one or more third model parameters.

The step of determining the third fitted fingerprint model may further comprise determining a combined set of second differences by combining multiple subsets of second differences in a weighted manner, wherein the multiple subsets of second differences are selected from respective sets of second differences determined for the same exposure field in the respective overlapping zones.

In an embodiment, the combined set of second differences may be determined by: 1) selecting a first subset of second differences from the set of second differences determined for the first exposure field in the first zone; 2) selecting a second subset of second differences from the set of second differences determined for the same exposure field in the second zone; 3) assigning a weight to each of the first subset of second differences and the second subset of second differences; and 4) determining the combined set of second differences by combining the first subset of second differences and the second subset of the second differences in a weighted manner.

As mentioned above, step 640 may result in multiple sets of second differences, wherein each set of second differences may be associated with a respective one of the zones. For each one of the zones, only a portion or subset of the corresponding set of second differences may be selected for fitting the third fingerprint model. The selected subset of second differences may be associated with measurement locations encompassed within the same exposure field in each overlapping zone.

By way of example and with reference to Figure 7, a first subset of second differences may be selected from the first set of second differences determined for the first zone Z1, a second subset of second differences may be selected from the second set of second differences determined for the second zone Z2, and a third subset of second differences may be selected from the third set of second differences determined for the third zone Z3. The combined set of second differences may then be determined by combining the first subset of second differences, the second subset of second differences, and the third subset of second differences in a combined manner. For example, the first subset of second differences may be assigned to a first weight of 0.25, the second subset of second differences may be assigned to a second weight of 0.5, and the third subset of second differences may be assigned to a third weight of 0.25. Thus, the combined set of second differences is the sum of the first subset of second differences multiplied by 0.25 and the second subset of second differences multiplied by 0.5 and the third subset of second differences multiplied by 0.25. The second subset of second differences is given a higher weight may be because exposure field 5 is in the center of the corresponding zone, i.e. zone Z2 but at the edge of zone Z1 and Z3. The weights may be determined based on other criteria.

The step of determining the third fitted fingerprint model may further comprise fitting the third fingerprint model to the combined set of second differences to determine the one or more third model parameters, thereby obtaining the third fitted fingerprint model.

Step 660 may comprise estimating the values of the performance parameter over the first exposure field using the third fitted fingerprint model.

Another aspect of the present disclosure may provide a computer program comprising program instructions operable to perform the above-described method 600, when run on a processing resource. The processing resource may comprise a processor and storage with such a computer program. In an embodiment, the processing resource may be a computing device comprised within a lithographic apparatus (e.g., the lithographic apparatus shown in Figure 1) and/or within a bonding apparatus for bonding a first substrate to a second substrate. In a different embodiment, the processing resource may be external to the lithographic apparatus and/or the bonding apparatus. The external processing unit may comprise cloud-based computing resources. In another different embodiment, the processing resource may be formed by a combination of internal and external computing devices.

The following numbered examples may demonstrate one or more aspects of the present disclosure.

Example 1: a method of estimating values of a performance parameter on a substrate, the substrate being divided into a plurality of exposure fields, the method comprising: providing a plurality of first differences between measured values of the performance parameter and estimated values of the performance parameter, wherein the measured values of the performance parameter are obtained after having measured the performance parameter at multiple different locations across at least a first portion of the substrate, and wherein the estimated values of the performance parameter are obtained at the same respective locations using a first fitted fingerprint model for estimating a first spatial distribution of the performance parameter over the at least a first portion of the substrate; defining one or more zones within the at least a first portion of the substrate, wherein each zone comprises a first exposure field and at least part of one or more second exposure fields; and estimating the values of the performance parameter over the first exposure field of each of the one or more zones from said plurality of first differences.

Example 2: the method of example 1, wherein said estimating the values of the performance parameter over the first exposure field of each of the one or more zones from said plurality of first differences comprises: determining, for each of the one or more zones, a second fitted fingerprint model for estimating a second spatial distribution of the performance parameter over the zone based on the plurality of first differences; determining, for each of the one or more zones, a plurality of second differences by comparing measured values of the performance parameter obtained at multiple different locations within the zone to estimated values of the performance parameter obtained at the same respective locations using the second fitted fingerprint model; and using said plurality of second differences in said estimating the values of the performance parameter over the first exposure field of each of the one or more zones.

Example 3: the method of example 2, wherein said determining, for each of the one or more zones, a second fitted fingerprint model for estimating a second spatial distribution of the performance parameter over the zone based on the plurality of first differences comprises: providing a second fingerprint model in relation to the second spatial distribution of the performance parameter over the corresponding zone, the second fingerprint model comprising one or more second model parameters; selecting a portion of the plurality of first differences associated with measurement locations encompassed within the corresponding zone; and fitting the second fingerprint model to the selected portion of the plurality of first differences to determine the one or more second model parameters and thus the second fitted fingerprint model.

Example 4: the method of example 2 or 3, wherein said using said plurality of second differences in said estimating the values of the performance parameter over the first exposure field of each of the one or more zones further comprises: determining, for each of the one or more zones, a third fitted fingerprint model for estimating a third spatial distribution of the performance parameter over the first exposure field of the corresponding zone based on the plurality of second differences; and estimating the values of the performance parameter over the first exposure field of each of the one or more zones using the third fitted fingerprint model.

Example 5: the method of example 4, wherein said determining, for each of the one or more zones, a third fitted fingerprint model for estimating a third spatial distribution of the performance parameter over the first exposure field of the corresponding zone based on the plurality of second differences comprises: providing a third fingerprint model in relation to the third spatial distribution of the performance parameter over the first exposure field of the corresponding zone, the third fingerprint model comprising one or more third model parameters; selecting a portion of the plurality of second differences associated with measurement locations encompassed within the first exposure field of the corresponding zone; and fitting the third fingerprint model to the selected portion of the plurality of second differences to determine the one or more third model parameters and thus the third fitted fingerprint model.

Example 6: the method of example 4, wherein said determining, for each of the one or more zones, a third fitted fingerprint model for estimating a third spatial distribution of the performance parameter over the first exposure field of the corresponding zone based on the plurality of second differences comprises: determining that the first exposure field is comprised within at least a first zone and a second zone; providing, for each of the at least a first zone and a second zone, a third fingerprint model in relation to the third spatial distribution of the performance parameter over the first exposure field of the corresponding zone, the third fingerprint model comprising one or more third model parameters; determining a combined set of second differences by combining multiple subsets of second differences in a weighted manner, wherein the multiple subsets of second differences are selected for the same exposure field in the respective overlapping zones; and fitting the third fingerprint model to the combined set of second differences to determine the one or more third model parameters and thus the third fitted fingerprint model.

Example 7: the method of any of examples 2 to 6, wherein said determining a combined set of second differences by combining multiple subsets of second differences in a weighted manner comprises: selecting a first subset of second differences from a first plurality of second differences determined for the first exposure field in the first zone; selecting a second subset of second differences from a second plurality of second differences determined for the same exposure field in the second zone; assigning a weight to each of the first subset of second differences and the second subset of second differences; and determining the combined set of second differences by combining the first subset of second differences and the second subset of the second differences in a weighted manner.

Example 8: the method of any of examples 1 to 7, wherein said providing a plurality of first differences comprises: providing a first fingerprint model in relation to the first spatial distribution of the performance parameter over the at least a first portion of the substrate, the first fingerprint model comprising one or more first model parameters; fitting the first fingerprint model to at least some of the measured values of the performance parameter to determine the one or more first model parameters and thus the first fitted fingerprint model; and determining the plurality of first differences by comparing measured values of the performance parameter obtained after having measured the performance parameter at multiple different locations across the at least a first portion of the substrate to estimated values of the performance parameter obtained at the same respective locations using the first fitted fingerprint model.

Example 9: the method of example 8, wherein the plurality of first differences comprises or consists of a set of fitting residuals resulting directly from performing the fitting step.

Example 10: the method of any of examples 1 to 9, wherein the first portion is at least a part of an irradiated layer inside or at the top surface of the substrate.

Example 11: the method of any of examples 1 to 10, wherein for each of the one or more zones, the one or more second exposure fields are arranged to substantially surround the first exposure field.

Example 12: the method of example 11, wherein for each of the one or more zones, the one or more second exposure fields are immediately adjacent to the first exposure field.

Example 13: the method of example 11, wherein for each of the one or more zones, the first exposure field and each of the one or more second exposure fields are separated by one or more other exposure fields.

Example 14: the method of example 11 or 12 or 13, wherein for each of the one or more zones, the one or more second exposure fields comprise at least two second exposure fields.

Example 15: the method of any of examples 1 to 14, wherein the performance parameter is one of: overlay error, critical dimension, alignment mark position, side wall angle, edge roughness, edge placement error, and focus error.

Example 16: the method of any of examples 2 to 15, wherein the first fingerprint model is same as or different to the second fingerprint model.

Example 17: the example of any of examples 4 to 16, wherein the first fingerprint and optionally the second fingerprint are a global fingerprint model, and the third fingerprint model is a field fingerprint model.

Example 18: a computer program comprising program instructions operable to perform the method of any of examples 1 to 17, when run on a processing resource.

Example 19: a non-transient computer program carrier comprising the computer program of example 18.

Example 20: a processing resource comprising a processor and the non-transient computer program carrier of example 19 with the computer program of example 18.

Example 21: a lithographic apparatus comprising the processing resource of example 20.

Example 22: a metrology apparatus comprising the processing resource of example 20.

Example 23: a bonding apparatus for bonding a first substrate to a second substrate comprising the processing resource of example 20.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of estimating values of a performance parameter on a substrate, the substrate being divided into a plurality of exposure fields, the method comprising:
   providing a plurality of first differences between measured values of the performance parameter and estimated values of the performance parameter, wherein the measured values of the performance parameter are obtained after having measured the performance parameter at multiple different locations across at least a first portion of the substrate, and wherein the estimated values of the performance parameter are obtained at the same respective locations using a first fitted fingerprint model for estimating a first spatial distribution of the performance parameter over the at least a first portion of the substrate;
   defining one or more zones within the at least a first portion of the substrate, wherein each zone comprises a first exposure field and at least part of one or more second exposure fields; and estimating the values of the performance parameter over the first exposure field of each of the one or more zones from said plurality of first differences.

2. A method as claimed in claim 1, wherein said estimating the values of the performance parameter over the first exposure field of each of the one or more zones from said plurality of first differences comprises:

   determining, for each of the one or more zones, a second fitted fingerprint model for estimating a second spatial distribution of the performance parameter over the zone based on the plurality of first differences;
   determining, for each of the one or more zones, a plurality of second differences by comparing measured values of the performance parameter obtained at multiple different locations within the zone to estimated values of the performance parameter obtained at the same respective locations using the second fitted fingerprint model; and
   using said plurality of second differences in said estimating the values of the performance parameter over the first exposure field of each of the one or more zones.

3. A method as claimed in claim 2, wherein said determining, for each of the one or more zones, a second fitted fingerprint model for estimating a second spatial distribution of the performance parameter over the zone based on the plurality of first differences comprises:

   providing a second fingerprint model in relation to the second spatial distribution of the performance parameter over the corresponding zone, the second fingerprint model comprising one or more second model parameters;
   selecting a portion of the plurality of first differences associated with measurement locations encompassed within the corresponding zone; and
   fitting the second fingerprint model to the selected portion of the plurality of first differences to determine the one or more second model parameters and thus the second fitted fingerprint model.

4. A method as claimed in claim 2 or 3, wherein said using said plurality of second differences in said estimating the values of the performance parameter over the first exposure field of each of the one or more zones further comprises:

   determining, for each of the one or more zones, a third fitted fingerprint model for estimating a third spatial distribution of the performance parameter over the first exposure field of the corresponding zone based on the plurality of second differences; and
   estimating the values of the performance parameter over the first exposure field of each of the one or more zones using the third fitted fingerprint model.

5. A method as claimed in claim 4, wherein said determining, for each of the one or more zones, a third fitted fingerprint model for estimating a third spatial distribution of the performance parameter over the first exposure field of the corresponding zone based on the plurality of second differences comprises:

providing a third fingerprint model in relation to the third spatial distribution of the performance parameter over the first exposure field of the corresponding zone, the third fingerprint model comprising one or more third model parameters;

selecting a portion of the plurality of second differences associated with measurement locations encompassed within the first exposure field of the corresponding zone; and

fitting the third fingerprint model to the selected portion of the plurality of second differences to determine the one or more third model parameters and thus the third fitted fingerprint model.

6. A method as claimed in claim 4, wherein said determining, for each of the one or more zones, a third fitted fingerprint model for estimating a third spatial distribution of the performance parameter over the first exposure field of the corresponding zone based on the plurality of second differences comprises:

determining that the first exposure field is comprised within at least a first zone and a second zone;

providing, for each of the at least a first zone and a second zone, a third fingerprint model in relation to the third spatial distribution of the performance parameter over the first exposure field of the corresponding zone, the third fingerprint model comprising one or more third model parameters;

determining a combined set of second differences by combining multiple subsets of second differences in a weighted manner, wherein the multiple subsets of second differences are selected for the same exposure field in the respective overlapping zones; and

fitting the third fingerprint model to the combined set of second differences to determine the one or more third model parameters and thus the third fitted fingerprint model.

7. A method as claimed in claim 6, wherein said determining a combined set of second differences by combining multiple subsets of second differences in a weighted manner comprises:

selecting a first subset of second differences from a first plurality of second differences determined for the first exposure field in the first zone;

selecting a second subset of second differences from a second plurality of second differences determined for the same exposure field in the second zone;

assigning a weight to each of the first subset of second differences and the second subset of second differences; and

determining the combined set of second differences by combining the first subset of second differences and the second subset of the second differences in a weighted manner.

8. A method as claimed in any preceding claim, wherein said providing a plurality of first differences comprises:

providing a first fingerprint model in relation to the first spatial distribution of the performance parameter over the at least a first portion of the substrate, the first fingerprint model comprising one or more first model parameters;

fitting the first fingerprint model to at least some of the measured values of the performance parameter to determine the one or more first model parameters and thus the first fitted fingerprint model; and

determining the plurality of first differences by comparing measured values of the performance parameter obtained after having measured the performance parameter at multiple different locations across the at least a first portion of the substrate to estimated values of the performance parameter obtained at the same respective locations using the first fitted fingerprint model;

optionally wherein the plurality of first differences comprises or consists of a set of fitting residuals resulting directly from performing the fitting step.

9. A method as claimed in any preceding claim, wherein the first portion is at least a part of an irradiated layer inside or at the top surface of the substrate.

10. A method as claimed in any preceding claim, wherein for each of the one or more zones, the one or more second exposure fields are immediately adjacent to the first exposure field.

11. A method as claimed in any of claims 1 to 9, wherein for each of the one or more zones, the first exposure field and each of the one or more second exposure fields are separated by one or more other exposure fields.

12. A computer program comprising program instructions operable to perform the method of any preceding claim, when run on a processing resource.

**13.** A non-transient computer program carrier comprising the computer program of claim 12.

**14.** A processing resource comprising a processor and the non-transient computer program carrier of claim 13 with the computer program of claim 12.

**15.** A lithographic apparatus or a metrology apparatus or a bonding apparatus comprising the processing resource of claim 14.

**Fig. 1**

252 254 256 258

250

**Fig. 2**

315

305 320 325 340 345

310 335 350

**Fig. 3**

Fig. 4

Fig. 5A

Fig. 5B

Fig. 6

Fig. 7

Europäisches
Patentamt

European
Patent Office

Office européen
des brevets

# EUROPEAN SEARCH REPORT

**Application Number**

EP 24 21 6497

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/191272 A1 (BUHL STEFAN [DE] ET AL) 24 June 2021 (2021-06-24) * the whole document * ----- | 1-15 | INV. G03F7/20 |
| A | US 2021/255547 A1 (VAN DONGEN JEROEN [NL] ET AL) 19 August 2021 (2021-08-19) * the whole document * ----- | 1-15 | |

|  |  |
|---|---|
| | **TECHNICAL FIELDS SEARCHED (IPC)** |
| | G03F G01N H01L |

The present search report has been drawn up for all claims

| Place of search | Date of completion of the search | Examiner |
|---|---|---|
| Munich | 30 April 2025 | Maslankiewicz, Pawel |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

...................................................................................

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 24 21 6497

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2025

| Patent document cited in search report | Publication date | Patent family member(s) | Publication date |
|---|---|---|---|
| US 2021191272 A1 | 24-06-2021 | CN 114746811 A | 12-07-2022 |
| | | JP 7569379 B2 | 17-10-2024 |
| | | JP 2023507780 A | 27-02-2023 |
| | | KR 20220119079 A | 26-08-2022 |
| | | TW 202125116 A | 01-07-2021 |
| | | US 2021191272 A1 | 24-06-2021 |
| | | WO 2021126605 A1 | 24-06-2021 |
| US 2021255547 A1 | 19-08-2021 | CN 112272796 A | 26-01-2021 |
| | | KR 20210010917 A | 28-01-2021 |
| | | TW 202001409 A | 01-01-2020 |
| | | US 2021255547 A1 | 19-08-2021 |
| | | WO 2019233743 A1 | 12-12-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- WO 2013092106 A
- WO 2016146217 A1
- WO 2018121921 A1